(19) Europäisches Patentamt
European Patent Office
Office européen des brevets

(11) **EP 3 875 967 B1**

(12) **FASCICULE DE BREVET EUROPÉEN**

(45) Date de publication et mention de la délivrance du brevet:
**26.11.2025 Bulletin 2025/48**

(21) Numéro de dépôt: **20160962.5**

(22) Date de dépôt: **04.03.2020**

(51) Classification Internationale des Brevets (IPC):
***G01R 1/067*** *(2006.01)*

(52) Classification Coopérative des Brevets (CPC):
**G01R 1/06777; H01B 17/308;** G01R 1/04

(54) **APPAREIL ÉLECTRIQUE À HAUTE TENSION**

HOCHSPANNUNGSELEKTROGERÄT

HIGH-VOLTAGE ELECTRICAL DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**08.09.2021 Bulletin 2021/36**

(73) Titulaire: **Sécheron SA**
**1242 Satigny (CH)**

(72) Inventeurs:
• **Schaerrer, Marc**
**1233 Bernex (CH)**

• **Venzin, Nicolas**
**74250 Fillinges (FR)**

(74) Mandataire: **Micheli & Cie SA**
**Rue de Genève 122**
**Case Postale 61**
**1226 Genève-Thônex (CH)**

(56) Documents cités:
| | |
|---|---|
| EP-A1- 3 291 379 | EP-A1- 3 364 196 |
| WO-A1-98/34309 | FR-A- 1 368 764 |
| FR-A1- 2 817 667 | FR-A1- 2 892 240 |
| JP-A- 2010 153 211 | US-A- 3 173 115 |
| US-A- 3 959 760 | US-A- 4 296 986 |
| US-A- 5 808 536 | US-A1- 2006 189 173 |

EP 3 875 967 B1

**Description**

La présente invention concerne un appareil électrique, à savoir un capteur de tension et/ou de courant ou un parafoudre, destiné à être connecté à une ligne d'alimentation à haute tension. Par « haute tension » on entend une tension nominale supérieure à 1 kV, de préférence supérieure à 10 kV, typiquement de 12,5 kV (à 60 Hz), de 15 kV (à 16,7 Hz) ou de 25 kV (à 50 ou 60 Hz). La tension peut être alternative ou continue.

La présente invention concerne en particulier un tel appareil électrique destiné à être placé sur ou dans un véhicule ferroviaire et à être connecté à une ligne d'alimentation à haute tension via un pantographe.

Un appareil électrique de ce type est décrit par exemple dans le brevet EP 3308174. Il comprend un isolateur dans lequel est placé un dispositif électrique, à savoir ici un diviseur de tension résistif, dont la borne supérieure est connectée à la haute tension. L'isolateur comprend un corps creux qui reçoit le dispositif électrique et une enveloppe entourant le corps creux. L'enveloppe définit des ailettes servant à maximiser la ligne de fuite. L'isolateur est monté sur une embase métallique qui renferme des composants électriques à basse tension reliés au dispositif électrique.

Dans un tel appareil, la cavité de l'isolateur qui reçoit le dispositif électrique est généralement remplie d'un matériau isolant sous forme de liquide, gaz ou solide. Il est en particulier connu de remplir la cavité de l'isolateur d'un matériau isolant solide souple pour renforcer l'isolation électrique du dispositif électrique et le protéger de l'humidité ainsi que des chocs et vibrations tout en limitant les contraintes mécaniques appliquées au dispositif électrique. Un inconvénient de ce type de matériau, toutefois, est son coefficient de dilatation élevé qui le conduit à se dilater et se contracter sensiblement lors d'une augmentation, respectivement une diminution, de la température. Ces dilatations et contractions provoquent des contraintes sur le dispositif électrique, sur les parois de la cavité et dans le matériau isolant lui-même. Si ces contraintes dépassent la résistance mécanique du matériau isolant ou l'adhérence du matériau isolant aux surfaces, il se rompt ou se décolle et ses performances en termes d'isolation électrique, de constante diélectrique, d'étanchéité et/ou de tenue mécanique sont dégradées. Une suite de dilatations et de contractions due aux changements de température de l'environnement ou provoquée par la dissipation interne de l'appareil lors de son fonctionnement soumet le matériau isolant à des contraintes variables voire cycliques qui le font vieillir et finissent par produire des défauts tels que des décollements, des cavités ou des fissures. Ces problèmes se posent de la même manière avec, à la place d'un dispositif électrique dans l'isolateur, un dispositif optique ou magnétique connecté à la haute tension.

La présente invention vise à atténuer les problèmes susmentionnés et propose à cette fin un appareil électrique selon la revendication 1 ou la revendication 6, des modes de réalisation particuliers étant définis dans les revendications dépendantes.

D'autres caractéristiques et avantages de la présente invention apparaîtront à la lecture de la description détaillée suivante faite en référence aux dessins annexés, dans lesquels :

- la figure 1 est une vue en coupe schématique d'un capteur (mesureur) de tension constituant un appareil électrique selon un exemple de réalisation de l'invention ;
- la figure 2 montre schématiquement, pour la comparaison, une cavité cylindrique et une cavité à tronçon tronconique remplies d'un matériau souple dilaté par la chaleur ;
- les figures 3 à 5 montrent schématiquement des exemples de formes alternatives pour la cavité d'un isolateur faisant partie de l'appareil électrique selon l'invention ;
- la figure 6 est une vue en coupe d'un moule utilisé lors de la fabrication de l'appareil électrique selon l'invention ;
- la figure 7 est une vue en perspective du moule illustré à la figure 6.

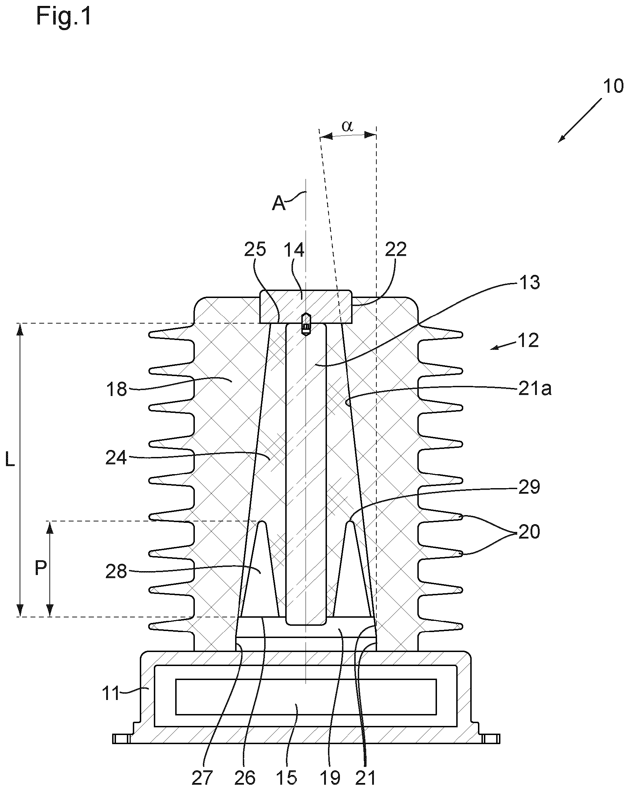

En référence à la figure 1, un appareil électrique 10 selon l'invention comprend une embase conductrice 11, un isolateur 12 monté sur l'embase conductrice 11 et un dispositif électrique 13 monté dans l'isolateur 12.

Le dispositif électrique 13 est connecté en partie supérieure de l'appareil 10 à une borne à haute tension 14 destinée à être connectée à une ligne d'alimentation à haute tension.

L'embase conductrice 11, typiquement métallique, est reliée à la terre et renferme un circuit électronique 15 comprenant des composants à basse tension tels que composants à semi-conducteurs, condensateurs, résistances, amplificateurs opérationnels, transformateurs, etc. permettant de traiter les signaux reçus du dispositif électrique 13. Un connecteur à basse tension (non représenté) sur l'embase conductrice 11 permet de connecter l'appareil 10 à un système électrique à basse tension.

Dans une application typique de l'invention, l'appareil électrique 10 est monté sur ou dans un véhicule ferroviaire, par exemple sur son toit, la borne à haute tension 14 est connectée par l'intermédiaire notamment d'un pantographe à une caténaire et le connecteur à basse tension est relié au reste du système à basse tension du véhicule.

Dans l'exemple représenté sur la figure 1, l'appareil électrique 10 est un capteur de tension et le dispositif électrique 13 est une résistance à haute tension faisant partie d'un diviseur de tension résistif et reliée électriquement au circuit électronique 15.

L'isolateur 12 comprend un corps creux 18 constitué d'un matériau électriquement isolant et rigide, par exemple de résine époxy (polymère époxyde). Le corps creux 18 présente des ailettes 20 à sa périphérie. Dans l'exemple représenté, l'isolateur 12 est monolithique. Il pourrait néanmoins être en plusieurs parties, par exemple il pourrait comprendre une enveloppe définissant les ailettes 20 et couvrant le corps creux 18. Un revêtement pourrait aussi couvrir la paroi de la cavité, 21, du corps creux 18.

La cavité 21 du corps creux 18 s'étend le long d'un axe A qui, dans l'exemple illustré, est aussi un axe pour l'isolateur 12, et est fermée en partie supérieure par la borne à haute tension 14 et en partie inférieure par l'embase conductrice 11. Le dispositif électrique 13 est monté dans cette cavité 21 en étant fixé par une de ses extrémités, par exemple par vissage comme représenté, à la borne à haute tension 14 elle-même maintenue dans un trou traversant 22 de la partie supérieure de l'isolateur 12. Au lieu d'être fixé à la borne à haute tension 14 ou en plus de sa fixation à la borne à haute tension 14, le dispositif électrique 13 peut être fixé à l'isolateur 12 en un ou plusieurs points le long du dispositif électrique 13.

La cavité 21 du corps creux 18, autour du dispositif électrique 13, est remplie sur tout ou partie de sa longueur d'un matériau électriquement isolant et souple, de préférence sous la forme d'un gel tel qu'un gel silicone, et de préférence encore sous la forme d'un gel collant ou gel silicone collant capable d'adhérer à la paroi de la cavité 21. Ce matériau isolant et souple forme un corps isolant 24 s'étendant le long de l'axe A et autour du dispositif électrique 13 entre une première surface d'extrémité 25 et une deuxième surface d'extrémité 26. La première surface d'extrémité 25 du corps isolant 24 est proche de la borne à haute tension 14 et même en contact avec cette dernière dans l'exemple illustré. La deuxième surface d'extrémité 26 du corps isolant 24 est, elle, située dans une partie à basse tension ou à plus basse tension de l'appareil 10, proche de l'embase conductrice 11. Cette deuxième surface d'extrémité 26 est en contact avec un gaz 19, par exemple de l'air ou de l'azote, et peut donc se déformer sous l'effet des dilatations et contractions thermiques du corps isolant 24.

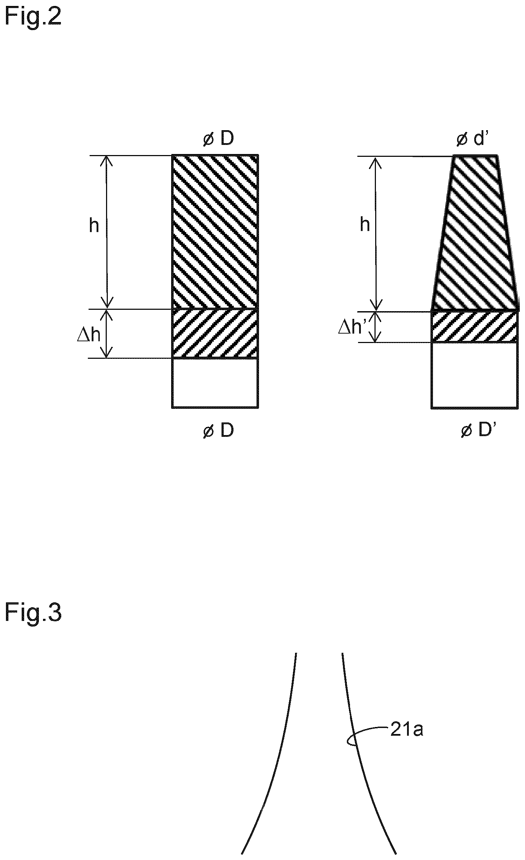

Au lieu d'être cylindrique, comme dans l'état de la technique, la cavité 21 du corps creux 18 est tronconique sur tout ou partie de sa longueur, de préférence sur au moins 30% voire au moins 50% voire au moins 70% de sa longueur, le reste de sa longueur pouvant être constitué d'un ou plusieurs tronçons cylindriques comme le tronçon 27 illustré sur la figure 1. Par le terme « tronconique » on entend dans le contexte de l'invention que la cavité 21 présente un tronçon 21a proprement tronconique (la génératrice est une droite ; cf. figure 1) ou plus généralement un tronçon 21a dont la section transversale augmente de façon strictement monotone dans un sens déterminé le long de l'axe A (la génératrice pouvant dans ce cas être une courbe, ayant par exemple la forme illustrée à la figure 3). Le sens déterminé est celui de la première surface d'extrémité 25 à la deuxième surface d'extrémité 26. Ainsi, la deuxième surface d'extrémité 26 du corps isolant 24 présente un plus grand diamètre externe que la première surface d'extrémité 25. L'angle de dépouille $\alpha$, ou demi-angle du tronçon tronconique 21a, est d'au moins 1,5°, de préférence d'au moins 2°, de préférence d'au moins 3°, de préférence d'au moins 4°, de préférence d'au moins 6°, de préférence d'au moins 8°, de préférence d'au moins 10°. Lorsque la génératrice du cône n'est pas une droite, l'angle de dépouille $\alpha$ est défini comme étant l'angle de dépouille moyen le long du tronçon tronconique 21a. Le tronçon tronconique 21a est de préférence de révolution mais il peut ne pas l'être et avoir par exemple une base elliptique. Dans ce cas, l'angle de dépouille $\alpha$ est défini comme étant l'angle de dépouille moyen autour de l'axe A.

Cette forme de la cavité 21 permet d'augmenter le volume disponible pour l'expansion du corps isolant 24 vers la surface libre (la deuxième surface d'extrémité 26), ce qui réduit le déplacement de la matière et les contraintes. En effet, notamment à diamètre externe de la première surface d'extrémité 25 ou de la deuxième surface d'extrémité 26 identique, la déformation de la deuxième surface d'extrémité 26 causée par des variations de température est réduite lorsque la cavité 21 est tronconique ou comprend un tronçon tronconique, par rapport à une cavité cylindrique. Ceci est illustré à la figure 2 où, selon une approximation du premier ordre dans laquelle la déformation de la surface libre est assimilée à un déplacement axial de toute la surface libre, la variation de hauteur $\Delta h$ d'un matériau placé dans une cavité cylindrique de diamètre D lors d'une variation de température $\Delta T$ peut être exprimée par la formule :

$$\Delta h = \Delta T * \beta * h$$

où h est la hauteur initiale du matériau et $\beta$ son coefficient de dilatation thermique. Pour un matériau placé dans une cavité tronconique de petit diamètre d'et de grand diamètre D', la variation de hauteur $\Delta h'$ pour une même hauteur initiale h que dans la cavité cylindrique est égale à :

$$\Delta h' = \Delta T * \beta * \frac{h}{3} * \left( 1 + \frac{d'}{D'} + \left( \frac{d'}{D'} \right)^2 \right)$$

Le rapport de la variation de position de la surface libre dans le cas d'une cavité tronconique sur la variation de position de la surface libre dans le cas d'une cavité cylindrique est donc de :

$$\frac{\Delta h'}{\Delta h} = \frac{1}{3}\left(1 + \frac{d'}{D'} + \left(\frac{d'}{D'}\right)^2\right)$$

soit une valeur inférieure à 1. Cette réduction de la déformation de la deuxième surface d'extrémité 26 diminue les contraintes dans la matière du corps isolant 24, sur le dispositif électrique 13 et sur la paroi de la cavité 21, et donc les risques de détérioration de l'intérieur de l'appareil 10.

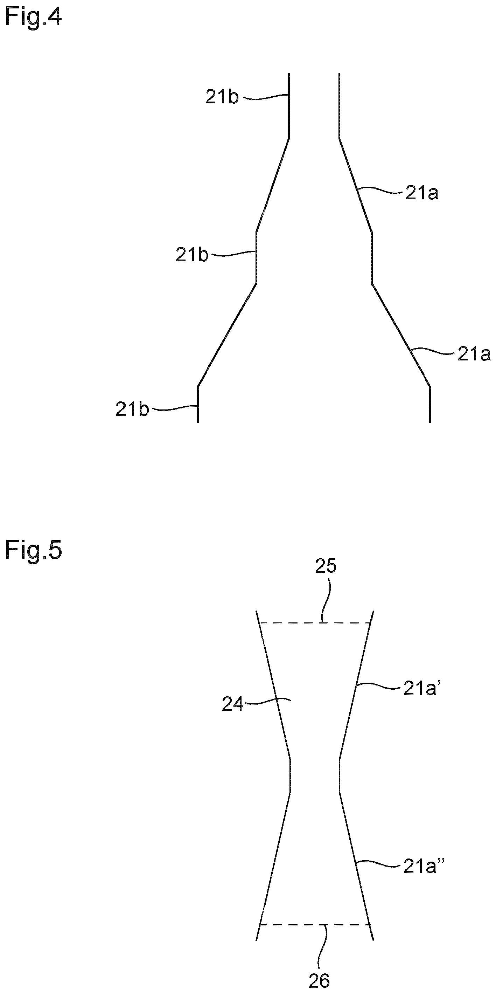

La cavité 21 peut comprendre plusieurs tronçons tronconiques 21a ayant des angles de dépouille, identiques ou différents, d'au moins 1,5°, ces tronçons tronconiques 21a alternant avec un ou des tronçons cylindriques 21b (cf. figure 4). Dans un tel cas, les tronçons tronconiques 21a cumulés représentent de préférence au moins 30% voire au moins 50% voire au moins 70% de la longueur de la cavité 21.

L'invention n'exclut pas la présence, en plus du ou des tronçons tronconiques 21a, d'un ou plusieurs tronçons tronconiques ayant des angles de dépouille inférieurs à 1,5°.

Dans l'exemple de réalisation représenté à la figure 1, la deuxième surface d'extrémité 26 du corps isolant 24 est libre tandis que la première surface d'extrémité 25, en contact avec la borne à haute tension 14, ne l'est pas. La configuration inverse est cependant possible, dans laquelle la première surface d'extrémité 25 serait libre et la deuxième surface d'extrémité 26 ne le serait pas parce qu'en contact avec un fond de l'isolateur 12 ou avec l'embase conductrice 11. Dans cette configuration, le ou les tronçons tronconiques 21a de la cavité 21 seraient bien entendu orientés dans le sens opposé à celui de la figure 1. Le corps isolant 24 pourrait aussi avoir ses deux surfaces d'extrémité 25, 26 libres. La cavité 21 pourrait alors avoir deux tronçons tronconiques 21a', 21a" s'évasant chacun vers une surface d'extrémité 25, 26 respective (cf. figure 5), chacun de ces tronçons tronconiques 21a', 21a" pouvant être remplacé par une succession de tronçons tronconiques orientés dans le même sens.

En référence de nouveau à la figure 1, et selon une autre caractéristique de l'invention, une rainure 28 est formée dans la ou les surfaces d'extrémité libres, en l'occurrence ici la deuxième surface d'extrémité 26, du corps isolant 24. Cette rainure 28 entoure l'axe A et le dispositif électrique 13. Elle est de préférence continue mais peut aussi être interrompue, c'est-à-dire formée d'une succession de trous ou rainures autour de l'axe A. Lorsque le corps isolant 24 est à température ambiante (20°C), la profondeur P de la rainure 28 est de préférence d'au moins 5%, de préférence encore d'au moins 10%, de préférence encore d'au moins 15% et de préférence encore d'au moins 20%, de la longueur L du corps isolant 24. Lorsque la température augmente, la profondeur P de la rainure 28 a tendance à diminuer jusqu'à s'annuler. De préférence, la profondeur P ne s'annule pas avant une température de 50°C, voire de 70°C, voire encore de 100°C, voire encore de 150°C dans le corps isolant 24.

Cette rainure 28 diminue le volume et augmente la surface libre du corps isolant 24, et limite les contraintes sur la matière proche de la surface lors des dilatations et contractions. Les parties du corps isolant 24 situées de part et d'autre de la rainure 28 peuvent se déformer radialement vers l'intérieur de la rainure 28, et la partie du corps isolant 24 située sous la rainure 28 (entre le fond 29 de la rainure 28 et la première surface d'extrémité 25) peut se déformer axialement vers l'intérieur de la rainure 28. Ainsi, les contraintes dans le corps isolant 24 et aux interfaces sont diminuées.

En section axiale, la rainure 28 présente typiquement une forme de V, comme représenté, ou de U. Son fond 29 est de préférence arrondi pour diminuer les contraintes. Le rayon de courbure du fond 29 est de préférence d'au moins 0,5 mm, de préférence encore d'au moins 2 mm, de préférence encore d'au moins 5 mm, de préférence encore d'au moins 7 mm.

Selon la forme de l'isolateur 12 et du dispositif électrique 13, la rainure 28 peut être circulaire, elliptique ou autre en section transversale.

Au lieu d'une seule rainure 28, la deuxième surface d'extrémité 26 du corps isolant 24 pourrait présenter plusieurs rainures entourant l'axe A, par exemple plusieurs rainures concentriques.

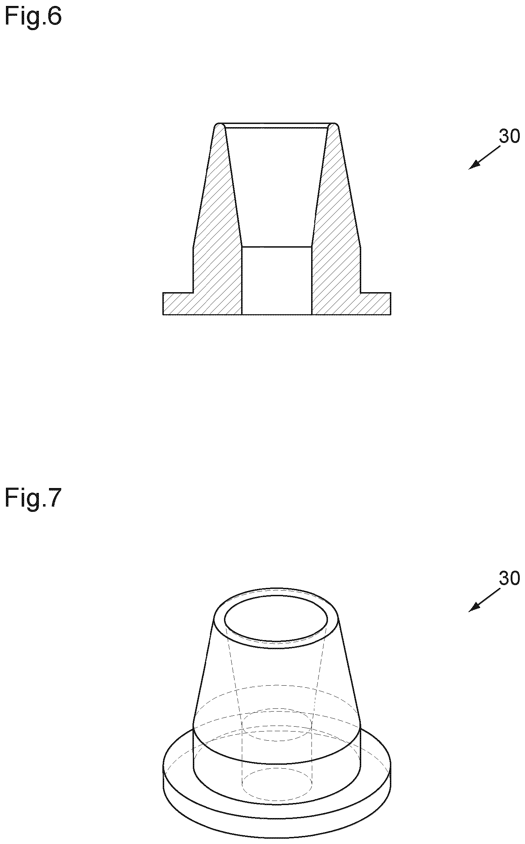

La ou les rainures 28 peuvent être formées au moyen d'un moule lors de la polymérisation du matériau du corps isolant 24 dans la cavité 21. Le moule peut être mis en place avant ou après l'injection dudit matériau dans la cavité 21. Un exemple de moule permettant de former la ou une des rainures 28 est représenté aux figures 6 et 7 et désigné par le repère 30.

Dans le cas où, à l'instar de la deuxième surface d'extrémité 26, la première surface d'extrémité 25 est libre, celle-ci peut aussi présenter une ou plusieurs rainures du type de la rainure 28, obtenues au moyen d'un deuxième moule.

La formation du corps isolant 24 est idéalement réalisée sous vide pour garantir l'absence de bulles nécessaire à une isolation haute tension de bonne qualité.

Par sa cavité 21, 21a de forme tronconique et sa ou ses rainures 28, la présente invention permet d'augmenter significativement le nombre de cycles thermiques que peut subir l'appareil 10 avant l'apparition de défauts dans le corps isolant 24. On notera néanmoins qu'une nette amélioration est déjà obtenue avec une seule de ces deux caractéristiques, à savoir soit la forme tronconique de la cavité 21, 21a soit la rainure 28, de sorte que ces caractéristiques peuvent aussi être utilisées indépendamment l'une de l'autre.

La présente invention est applicable à d'autres appareils électriques qu'un capteur de tension, à savoir à un capteur de courant ou à un parafoudre.

Selon le type de l'appareil électrique 10, le dispositif électrique 13 pourrait être sous la forme d'un circuit imprimé.

L'invention est applicable en outre à des appareils électriques dans lesquels le dispositif 13 n'est pas électrique mais optique ou magnétique. Le dispositif 13 pourrait en effet consister, par exemple, en une ou plusieurs fibres optiques ou en un ou plusieurs cylindres transparents connectés à la borne à haute tension 14 par l'intermédiaire d'un dispositif optoélectronique, pour transmettre de l'information de la partie à haute tension à la partie à basse tension de l'appareil et/ou inversement. Le dispositif 13 pourrait aussi consister en un ou plusieurs transformateurs servant à transmettre de l'énergie de la partie à basse tension à la partie à haute tension de l'appareil pour alimenter un circuit de la partie à haute tension ou transmettre des informations. On pourrait même avoir un dispositif 13 comprenant une partie électrique, une partie optique et/ou une partie magnétique.

**Revendications**

1. Appareil électrique, à savoir capteur de tension et/ou de courant ou parafoudre, comprenant un premier corps isolant (18), une cavité (21) s'étendant le long d'un axe (A) dans le premier corps isolant (18), un dispositif électrique, optique et/ou magnétique (13) situé dans la cavité (21), une borne à haute tension (14) située à une extrémité de la cavité (21) et à laquelle est connecté ledit dispositif (13), et un deuxième corps isolant (24) remplissant la cavité (21), autour dudit dispositif (13), sur au moins une partie de la longueur de la cavité (21), le matériau du deuxième corps isolant (24) étant plus souple que celui du premier corps isolant (18), le deuxième corps isolant (24) s'étendant le long de l'axe (A) entre une première surface d'extrémité (25) et une deuxième surface d'extrémité (26), la deuxième surface d'extrémité (26) étant libre de se déformer sous l'effet des variations de température, l'une des première et deuxième surfaces d'extrémité (25, 26) étant proche de la borne à haute tension (14) ou en contact avec cette dernière, l'autre des première et deuxième surfaces d'extrémité (25, 26) étant située dans une partie à plus basse tension de l'appareil électrique, **caractérisé en ce que** la cavité (21) comprend au moins un tronçon tronconique (21a) dont l'angle de dépouille ($\alpha$) est d'au moins 1,5°, qui est rempli sur au moins une partie de sa longueur, autour dudit dispositif (13), par le deuxième corps isolant (24), et qui est évasé dans le sens de la première surface d'extrémité (25) à la deuxième surface d'extrémité (26).

2. Appareil électrique selon la revendication 1, **caractérisé en ce que** l'angle de dépouille ($\alpha$) du tronçon tronconique (21a) ou de l'un au moins des tronçons tronconiques (21a) est d'au moins 2°, de préférence d'au moins 3°, de préférence d'au moins 4°, de préférence d'au moins 6°, de préférence d'au moins 8°, de préférence d'au moins 10°.

3. Appareil électrique selon la revendication 1 ou 2, **caractérisé en ce que** le tronçon tronconique (21a) ou les tronçons tronconiques (21a) cumulés s'étend(ent) sur au moins 30%, de préférence au moins 50%, de préférence au moins 70%, de la longueur de la cavité (21).

4. Appareil électrique selon l'une quelconque des revendications 1 à 3, **caractérisé en ce que** la première surface d'extrémité (25) est libre de se déformer sous l'effet des variations de température, et **en ce que** la cavité (21) comprend en outre au moins un tronçon tronconique (21a') dont l'angle de dépouille est d'au moins 1,5°, qui est rempli sur au moins une partie de sa longueur, autour dudit dispositif (13), par le deuxième corps isolant (24) et qui est évasé dans le sens de la deuxième surface d'extrémité (26) à la première surface d'extrémité (25).

5. Appareil électrique selon l'une quelconque des revendications 1 à **4, caractérisé en ce qu'**à température ambiante le deuxième corps isolant (24) présente au moins une rainure (28) dans sa deuxième surface d'extrémité (26), autour de l'axe (A).

6. Appareil électrique, à savoir capteur de tension et/ou de courant ou parafoudre, comprenant un premier corps isolant (18), une cavité (21) s'étendant le long d'un axe (A) dans le premier corps isolant (18), un dispositif électrique, optique et/ou magnétique (13) situé dans la cavité (21), une borne à haute tension (14) située à une extrémité de la cavité (21) et à laquelle est connecté ledit dispositif (13), et un deuxième corps isolant (24) remplissant la cavité (21), autour dudit dispositif (13), sur au moins une partie de la longueur de la cavité (21), le matériau du deuxième corps isolant (24) étant plus souple que celui du premier corps isolant (18), le deuxième corps isolant (24) s'étendant le long de l'axe (A) entre une première surface d'extrémité (25) et une deuxième surface d'extrémité (26), la deuxième surface d'extrémité (26) étant libre de se déformer sous l'effet des variations de température, l'une des première et deuxième surfaces d'extrémité (25, 26) étant proche de la borne à haute tension (14) ou en contact avec cette dernière, l'autre des première et deuxième surfaces d'extrémité (25, 26) étant située dans une partie à plus basse tension de l'appareil électrique, **caractérisé en ce qu'**à température ambiante le deuxième corps isolant (24) présente au moins une rainure (28) dans sa deuxième surface d'extrémité (26), autour de l'axe (A).

7. Appareil électrique selon la revendication 5 ou 6, **caractérisé en ce qu'**à température ambiante la profondeur (P) de la rainure (28) est d'au moins 5%, de préférence d'au moins 10%, de préférence d'au moins 15%, de préférence d'au moins 20% de la longueur (L) du deuxième corps isolant (24).

8. Appareil électrique selon l'une quelconque des revendications 5 à 7, **caractérisé en ce que** la profondeur (P) de la rainure (28) ne s'annule pas avant une température de 50°C, de préférence de 70°C, de préférence de 100°C, de préférence de 150°C.

9. Appareil électrique selon l'une quelconque des revendications 5 à 8, **caractérisé en ce que** le fond (29) de la rainure (28) est arrondi.

10. Appareil électrique selon la revendication 9, **caractérisé en ce que** le rayon de courbure du fond (29) de la rainure (28) est d'au moins 0,5 mm, de préférence d'au moins 2 mm, de préférence d'au moins 5 mm, de préférence d'au moins 7 mm.

11. Appareil électrique selon l'une quelconque des revendications 1 à 10, **caractérisé en ce que** la borne à haute tension (14) est plus proche de la première extrémité (25) que de la deuxième extrémité (26).

12. Appareil électrique selon l'une quelconque des revendications 1 à 11, **caractérisé en ce que** le premier corps isolant (18) est monté sur une embase conductrice (11).

13. Appareil électrique selon la revendication 12, **caractérisé en ce que** l'embase conductrice (11) renferme une partie électronique à basse tension (15).

14. Appareil électrique selon l'une quelconque des revendications 1 à 13, **caractérisé en ce que** le matériau du premier corps isolant (18) comprend de la résine époxy.

15. Appareil électrique selon l'une quelconque des revendications 1 à 14, **caractérisé en ce que** le matériau du deuxième corps isolant (24) est un gel, de préférence un gel silicone.

16. Utilisation de l'appareil électrique selon l'une quelconque des revendications 1 à 15 dans le domaine ferroviaire.


**Patentansprüche**

1. Elektrisches Gerät, nämlich Spannungs- und/oder Stromsensor oder Überspannungsschutz, umfassend einen ersten Isolierkörper (18), einen Hohlraum (21), der sich entlang einer Achse (A) im ersten Isolierkörper (18) erstreckt, eine elektrische, optische und/oder magnetische Vorrichtung (13), die sich im Hohlraum (21) befindet, einen Hochspannungsanschluss (14), der sich an einem Ende des Hohlraums (21) befindet und mit dem die Vorrichtung (13) verbunden ist, und einen zweiten Isolierkörper (24), der den Hohlraum (21) um die Vorrichtung (13) herum über mindestens einen Teil der Länge des Hohlraums (21) ausfüllt, wobei das Material des zweiten Isolierkörpers (24) flexibler ist als das des ersten Isolierkörpers (18), wobei sich der zweite Isolierkörper (24) entlang der Achse (A) zwischen einer ersten Endfläche (25) und einer zweiten Endfläche (26) erstreckt, wobei die zweite Endfläche (26) sich unter dem Einfluss von Temperaturschwankungen frei verformen kann, wobei eine der ersten und zweiten Endflächen (25, 26) nahe am Hochspannungsanschluss (14) oder in Kontakt mit diesem liegt, wobei die andere der ersten und zweiten Endflächen (25, 26) sich in einem Teil des elektrischen Geräts mit niedrigerer Spannung befindet, **dadurch gekennzeichnet, dass** der Hohlraum (21) mindestens einen kegelstumpfförmigen Abschnitt (21a) umfasst, dessen halben Kegelwinkel ($\alpha$) mindestens 1,5° beträgt, der über mindestens einen Teil seiner Länge um die Vorrichtung (13) herum mit dem zweiten Isolierkörper (24) gefüllt ist und der in Richtung der ersten Endfläche (25) zur zweiten Endfläche (26) hin aufgeweitet ist.

2. Elektrisches Gerät nach Anspruch 1, **dadurch gekennzeichnet, dass** der halbe Kegelwinkel ($\alpha$) des kegelstumpfförmigen Abschnitts (21a) oder mindestens eines der kegelstumpfförmigen Abschnitte (21a) mindestens 2°, vorzugsweise mindestens 3°, vorzugsweise mindestens 4°, vorzugsweise mindestens 6°, vorzugsweise mindestens 8°, vorzugsweise mindestens 10° beträgt.

3. Elektrisches Gerät nach Anspruch 1 oder 2, **dadurch gekennzeichnet, dass** sich der kegelstumpfförmige Abschnitt (21a) oder die kegelstumpfförmigen Abschnitte (21a) insgesamt über mindestens 30 %, vorzugsweise mindestens 50 %, vorzugsweise mindestens 70 % der Länge des Hohlraums (21) erstrecken.

4. Elektrisches Gerät nach einem der Ansprüche 1 bis 3, **dadurch gekennzeichnet, dass** die erste Endfläche (25) sich unter dem Einfluss von Temperaturschwankungen frei verformen kann und dass der Hohlraum (21) ausserdem mindestens einen kegelstumpfförmigen Abschnitt (21a') umfasst, dessen halben Kegelwinkel mindestens 1,5° beträgt, der über mindestens einen Teil seiner Länge um die Vorrichtung (13) herum mit dem zweiten Isolierkörper (24) gefüllt ist und der in Richtung der zweiten Endfläche (26) zur ersten Endfläche (25) hin aufgeweitet ist.

5. Elektrisches Gerät nach einem der Ansprüche 1 bis 4, **dadurch gekennzeichnet, dass** der zweite Isolierkörper (24) bei Umgebungstemperatur mindestens eine Nut (28) in seiner zweiten Endfläche (26) um die Achse (A) aufweist.

6. Elektrisches Gerät, nämlich Spannungs- und/oder Stromsensor oder Überspannungsschutz, umfassend einen ersten Isolierkörper (18), einen Hohlraum (21), der sich entlang einer Achse (A) im ersten Isolierkörper (18) erstreckt, eine elektrische, optische und/oder magnetische Vorrichtung (13), die sich im Hohlraum (21) befindet, einen Hochspannungsanschluss (14), der sich an einem Ende des Hohlraums (21) befindet und mit dem die Vorrichtung (13) verbunden ist, und einen zweiten Isolierkörper (24), der den Hohlraum (21) um die Vorrichtung (13) herum über mindestens einen Teil der Länge des Hohlraums (21) ausfüllt, wobei das Material des zweiten Isolierkörpers (24) flexibler ist als das des ersten Isolierkörpers (18), wobei sich der zweite Isolierkörper (24) entlang der Achse (A) zwischen einer ersten Endfläche (25) und einer zweiten Endfläche (26) erstreckt, wobei die zweite Endfläche (26) sich unter dem Einfluss von Temperaturschwankungen frei verformen kann, wobei eine der ersten und zweiten Endflächen (25, 26) nahe am Hochspannungsanschluss (14) oder in Kontakt mit diesem liegt, wobei sich die andere der ersten und zweiten Endflächen (25, 26) in einem Teil des elektrischen Geräts mit niedrigerer Spannung befindet, **dadurch gekennzeichnet, dass** der zweite Isolierkörper (24) bei Raumtemperatur mindestens eine Nut (28) in seiner zweiten Endfläche (26) um die Achse (A) herum aufweist.

7. Elektrisches Gerät nach Anspruch 5 oder 6, **dadurch gekennzeichnet, dass** bei Raumtemperatur die Tiefe (P) der Nut (28) mindestens 5 %, vorzugsweise mindestens 10 %, vorzugsweise mindestens 15 %, vorzugsweise mindestens 20 % der Länge (L) des zweiten Isolierkörpers (24) beträgt.

8. Elektrisches Gerät nach einem der Ansprüche 5 bis 7, **dadurch gekennzeichnet, dass** die Tiefe (P) der Nut (28) erst bei einer Temperatur von 50 °C, vorzugsweise 70 °C, vorzugsweise 100 °C, vorzugsweise 150 °C verschwindet.

9. Elektrisches Gerät nach einem der Ansprüche 5 bis 8, **dadurch gekennzeichnet, dass** der Boden (29) der Nut (28) abgerundet ist.

10. Elektrisches Gerät nach Anspruch 9, **dadurch gekennzeichnet, dass** der Krümmungsradius des Bodens (29) der Nut (28) mindestens 0,5 mm, vorzugsweise mindestens 2 mm, vorzugsweise mindestens 5 mm, vorzugsweise mindestens 7 mm beträgt.

11. Elektrisches Gerät nach einem der Ansprüche 1 bis 10, **dadurch gekennzeichnet, dass** der Hochspannungsanschluss (14) näher am ersten Ende (25) als am zweiten Ende (26) liegt.

12. Elektrisches Gerät nach einem der Ansprüche 1 bis 11, **dadurch gekennzeichnet, dass** der erste Isolierkörper (18) auf einer leitenden Basis (11) angebracht ist.

13. Elektrisches Gerät nach Anspruch 12, **dadurch gekennzeichnet, dass** die leitende Basis (11) einen Niederspannungs-Elektronikteil (15) enthält.

14. Elektrisches Gerät nach einem der Ansprüche 1 bis 13, **dadurch gekennzeichnet, dass** das Material des ersten Isolierkörpers (18) Epoxidharz umfasst.

15. Elektrisches Gerät nach einem der Ansprüche 1 bis 14, **dadurch gekennzeichnet, dass** das Material des zweiten Isolierkörpers (24) ein Gel, vorzugsweise ein Silikongel, ist.

16. Verwendung des elektrischen Geräts nach einem der Ansprüche 1 bis 15 im Eisenbahnbereich.

**Claims**

1. Electrical apparatus, namely a voltage and/or current sensor or surge arrester, comprising a first insulating body (18), a cavity (21) extending along an axis (A) in the first insulating body (18), an electrical, optical and/or magnetic device (13) located in the cavity (21), a high-voltage terminal (14) located at one end of the cavity (21) and to which said device (13) is connected, and a second insulating body (24) filling the cavity (21) around said device (13) over at least part of the length of the cavity (21), the material of the second insulating body (24) being more flexible than that of the first insulating body (18), the second insulating body (24) extending along the axis (A) between a first end surface (25) and a second end surface (26), the second end surface (26) being free to deform under the effect of temperature variations, one of the first and second end surfaces (25, 26) being close to or in contact with the high-voltage terminal (14), the other of the first and second end surfaces (25, 26) being located in a lower voltage part of the electrical apparatus, **characterised in that** the cavity (21) comprises at least one truncated conical section (21a) whose taper angle ($\alpha$) is at least 1.5°, which is filled over at least part of its length, around said device (13), by the second insulating body (24), and which flares in the direction from the first end surface (25) to the second end surface (26).

2. Electrical apparatus according to claim 1, **characterised in that** the taper angle ($\alpha$) of the truncated conical section (21a) or of at least one of the truncated conical sections (21a) is at least 2°, preferably at least 3°, preferably at least 4°, preferably at least 6°, preferably at least 8°, preferably at least 10°.

3. Electrical apparatus according to claim 1 or 2, **characterised in that** the truncated conical section (21a) or the combined truncated conical sections (21a) extend over at least 30%, preferably at least 50%, preferably at least 70%, of the length of the cavity (21).

4. Electrical apparatus according to any of claims 1 to 3, **characterised in that** the first end surface (25) is free to deform under the effect of temperature variations, and **in that** the cavity (21) further comprises at least one truncated conical section (21a') with a taper angle of at least 1.5°, which is filled over at least part of its length, around said device (13), by the second insulating body (24) and which flares in the direction from the second end surface (26) to the first end surface (25).

5. Electrical apparatus according to any of claims 1 to 4, **characterised in that** at ambient temperature the second insulating body (24) has at least one groove (28) in its second end surface (26), around the axis (A).

6. Electrical device, namely a voltage and/or current sensor or surge arrester, comprising a first insulating body (18), a cavity (21) extending along an axis (A) in the first insulating body (18), an electrical, optical and/or magnetic device (13) located in the cavity (21), a high-voltage terminal (14) located at one end of the cavity (21) and to which said device (13) is connected, and a second insulating body (24) filling the cavity (21) around said device (13) over at least part of the length of the cavity (21), the material of the second insulating body (24) being more flexible than that of the first insulating body (18), the second insulating body (24) extending along the axis (A) between a first end surface (25) and a second end surface (26), the second end surface (26) being free to deform under the effect of temperature variations, one of the first and second end surfaces (25, 26) being close to or in contact with the high-voltage terminal (14), the other of the first and second end surfaces (25, 26) being located in a lower voltage part of the electrical apparatus, **characterised in that** at ambient temperature the second insulating body (24) has at least one groove (28) in its second end surface (26), around the axis (A).

7. Electrical apparatus according to claim 5 or 6, **characterised in that** at ambient temperature the depth (P) of the groove (28) is at least 5%, preferably at least 10%, preferably at least 15%, preferably at least 20% of the length (L) of the second insulating body (24).

8. Electrical apparatus according to any of claims 5 to 7, **characterised in that** the depth (P) of the groove (28) does not become zero before a temperature of 50°C, preferably 70°C, preferably 100°C, preferably 150°C.

9. Electrical apparatus according to any of claims 5 to 8, **characterised in that** the bottom (29) of the groove (28) is rounded.

10. Electrical apparatus according to claim 9, **characterised in that** the radius of curvature of the bottom (29) of the groove (28) is at least 0.5 mm, preferably at least 2 mm, preferably at least 5 mm, preferably at least 7 mm.

11. Electrical apparatus according to any of claims 1 to 10, **characterised in that** the high-voltage terminal (14) is closer to the first end (25) than to the second end (26).

12. Electrical apparatus according to any one of claims 1 to 11, **characterised in that** the first insulating body (18) is mounted on a conductive base (11).

13. Electrical apparatus according to claim 12, **characterised in that** the conductive base (11) contains a low-voltage electronic part (15).

14. Electrical apparatus according to any one of claims 1 to 13, **characterised in that** the material of the first insulating body (18) comprises epoxy resin.

15. Electrical apparatus according to any of claims 1 to 14, **characterised in that** the material of the second insulating body (24) is a gel, preferably a silicone gel.

16. Use of the electrical apparatus according to any of claims 1 to 15 in the railway sector.

Fig.1

Fig.2

ø D

h

Δh

ø D

ø d'

h

Δh'

ø D'

Fig.3

21a

Fig.4

21b

21a

21b

21b

21a

Fig.5

25

24

21a'

21a''

26

Fig.6

30

Fig.7

30

## RÉFÉRENCES CITÉES DANS LA DESCRIPTION

**Documents brevets cités dans la description**

- EP 3308174 A